# DEMANDE DE BREVET EUROPEEN

(11) **EP 3 719 978 A1**
(43) Date de publication de la demande: **07.10.2020**
(21) Numéro de dépôt: 20162852.6
(22) Date de dépôt: 12.03.2020
(51) Int. Cl.: H02K 11/33, H02M 7/00

(54) **ONDULEUR COMPRENANT UNE PARTIE FORMANT UN DECROCHEMENT DEPUIS UNE PREMIERE PARTIE DE L'ONDULEUR**

(30) Priorité: 05.04.2019 FR 1903710
(71) Demandeur: Valeo Siemens eAutomotive France SAS, 95800 Cergy (FR)
(72) Inventeur: GILET, Olivier, 95270 VIARMES (FR); LAMARCHE, Anthony, 78450 VILLEPREUX (FR)
(74) Mandataire: Argyma

(57) **Abrégé**

L'invention concerne un onduleur (200), notamment configuré pour être embarqué dans un véhicule automobile, comprenant :
- des composants de puissance configurés pour convertir une énergie électrique continue en une énergie électrique alternative de façon à alimenter un moteur électrique (250), notamment destiné à entrainer le véhicule,
- un boitier (100) logeant les composants de l'onduleur (200) et comprenant une première partie (110) formant un premier logement logeant lesdits composants de puissance et une deuxième partie (120) formant un deuxième logement logeant des composants de filtrage configurés pour filtrer une énergie électrique continue fournie aux composants de puissance, notamment depuis une batterie du véhicule,
ladite deuxième partie (120) de boitier étant formée au moins en partie par un décrochement (124) par rapport à ladite première partie (110) depuis une face externe (114) du boitier comprise dans la première partie (110).

## Description

### DOMAINE TECHNIQUE DE L'INVENTION

La présente invention concerne un onduleur, notamment configuré pour être embarqué dans un véhicule automobile, en particulier un véhicule électrique ou hybride. L'invention concerne aussi un ensemble comprenant ledit onduleur et un moteur électrique, notamment destiné à entrainer les roues du véhicule automobile.

### ETAT DE LA TECHNIQUE

Ces dernières années, les technologies liées aux véhicules électriques ou hybrides, se sont rapidement développées. Typiquement, un véhicule électrique ou hybride comprend un moteur électrique générant une force de rotation, un onduleur pour commander ledit moteur électrique, une batterie pour alimenter ledit onduleur, et également une boîte de vitesses pour transférer un couple aux roues du véhicule depuis le moteur électrique. On recherche comment placer ces composants dans le véhicule de manière à limiter la l'encombrement des composants dans le véhicule. À cette fin, il est connu de fournir un ensemble intégré dans lequel ces composants sont montés les uns avec les autres afin d'optimiser la place dans le véhicule et d'éviter des câbles parcourant des distances dans le véhicule. Cependant, un simple montage des composants les uns sur les autres ne garantit pas un gain de place suffisant dans le véhicule. L'arrangement interne de chaque composant, en particulier de l'onduleur, impacte également l'encombrement de l'ensemble.

Il est donc recherché un onduleur ayant un arrangement interne avantageant son montage avec d'autres composants d'un ensemble formant notamment un système d'entrainement d'un véhicule.

### PRESENTATION DE L'INVENTION

A cet effet, l'invention concerne un onduleur, notamment configuré pour être embarqué dans un véhicule automobile, comprenant :
des composants de puissance configurés pour convertir une énergie électrique continue en une énergie électrique alternative de façon à alimenter un moteur électrique, notamment destiné à entrainer le véhicule,
un boitier logeant les composants de l'onduleur et comprenant :
une première partie formant un premier logement logeant lesdits composants de puissance et
une deuxième partie formant un deuxième logement logeant des composants de filtrage configurés pour filtrer une énergie électrique continue fournie aux composants de puissance, notamment depuis une batterie du véhicule,
ladite deuxième partie de boitier étant formée au moins en partie par un décrochement par rapport à ladite première partie depuis une face externe du boitier comprise dans la première partie.

Ladite deuxième partie s'étend depuis la première partie suivant une direction transverse, notamment perpendiculaire par rapport à la première partie. Ainsi, lorsque l'onduleur est monté dans un véhicule, l'espace formé entre la première partie et la deuxième partie de boitier peut recevoir un autre composant du véhicule, notamment le moteur électrique alimenté par l'onduleur, ce qui améliore l'intégration des composants dans le véhicule.

Selon un mode de réalisation, le décrochement forme une face externe du boitier comprise dans la deuxième partie et s'étend suivant une direction transversale, en particulier perpendiculaire, par rapport à la face externe du boitier comprise dans la première partie.

Selon un mode de réalisation, une face externe de la deuxième partie de boitier comprend un premier connecteur externe de l'onduleur configuré pour connecter l'onduleur à une source d'énergie électrique continue, notamment la batterie du véhicule.

Selon une variante, ledit premier connecteur est à une position distale depuis la première partie de boitier, lesdits composants de filtrage étant positionnés entre cette position distale et le point de décrochement entre la première partie et la deuxième partie.

Selon une variante, ledit connecteur est monté sur la face externe de la deuxième partie qui forme un décrochement depuis la face externe de la première partie.

Selon un mode de réalisation, la deuxième partie de boitier comprend en outre un deuxième connecteur externe configuré pour connecter l'onduleur avec un chargeur, notamment un chargeur électrique configuré pour charger une batterie du véhicule.

Selon un mode de réalisation, un passage à l'intérieur du boitier permet une communication entre le premier et le deuxième logement.

Selon un mode de réalisation, la deuxième partie comprend une ouverture destinée à recevoir un arbre de d'entrainement d'un véhicule lorsque l'onduleur est monté dans un véhicule, en particulier un axe d'entrainement des roues du véhicule.

Selon une variante, ladite ouverture est formée dans ledit décrochement.

Selon une variante, ladite ouverture est formée dans une portion de la deuxième partie de boitier qui est extérieure au deuxième logement logeant les composants de filtrage.

L'invention concerne en outre un ensemble comprenant un onduleur selon l'invention et un moteur électrique configuré pour être entrainé par ledit onduleur.

Selon un mode de réalisation, ledit moteur électrique est logé au moins en partie dans l'espace formé entre la première partie et la deuxième partie de boitier, en particulier dans l'espace formée entre la face externe de la première partie et le décrochement.

Selon une variante, une ouverture du moteur électrique et une ouverture de l'onduleur viennent l'une contre l'autre dans l'espace formé entre la première partie et la deuxième partie de boitier de façon à permettre un passage étanche pour une connexion électrique entre l'onduleur et le moteur électrique.

Selon une variante particulière, une ouverture du boitier contenant le stator du moteur électrique et une ouverture du boitier de l'onduleur viennent l'une contre l'autre dans l'espace formé entre la première partie et la deuxième partie de boitier de façon à permettre un passage étanche pour une connexion électrique entre l'onduleur et le moteur.

### PRESENTATION DES FIGURES

L'invention sera mieux comprise et d'autres détails, caractéristiques et avantages de l'invention apparaîtront à la lecture de la description suivante faite à titre d'exemple non limitatif en référence aux figures annexées dans lesquelles :
[Fig.1] : la figure 1 représente un exemple d'onduleur selon un mode de réalisation ;
[Fig.2] : la figure 2 présente une vue partielle de l'onduleur :

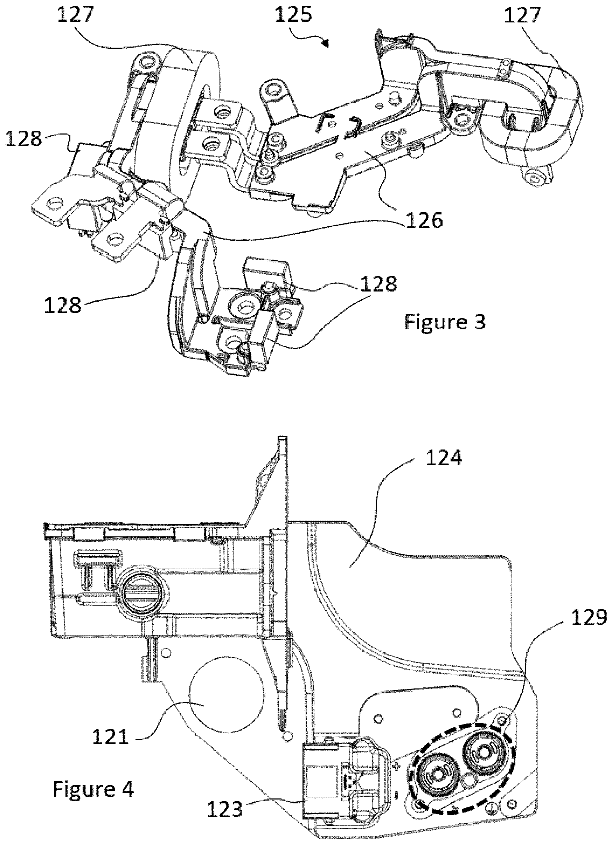

[Fig.3] : la figure 3 illustre un exemple de composants de filtrage de l'onduleur :
[Fig.4] : la figure 4 présente une autre vue de l'onduleur ;
[Fig.5] : la figure 5 représente un exemple d'ensemble comprenant l'onduleur ;
[Fig.6] : la figure 6 présente une autre vue de l'onduleur ;
[Fig.7] : la figure 7 représente une variante de l'onduleur.

Il faut noter que les figures exposent l'invention de manière détaillée pour mettre en œuvre l'invention, lesdites figures pouvant bien entendu servir à mieux définir l'invention le cas échéant.

### DESCRIPTION DETAILLEE DE L'INVENTION

L'exemple d'onduleur 200 comprend un boitier 100 dans lequel les composants de l'onduleur 200 sont logés. Le boitier 100 comprend une première partie 110 qui forme un premier logement logeant des composants de puissance de l'onduleur 200, et une deuxième partie 120 qui forme un deuxième logement 122 logeant des composants de filtrage 125 de l'onduleur 200. La deuxième partie 120 du boitier 100 est formée au moins en partie par un décrochement 124 depuis une face externe 114 du boitier 100 comprise dans la première partie 110. La deuxième partie 120 s'étend donc depuis la première partie 110 suivant une direction transverse, voire perpendiculaire, par rapport à la première partie 110. Ainsi, le boitier 100 délimite un espace entre la première partie 110 et la deuxième partie 120 qui est susceptible de recevoir d'autres composants d'un véhicule lorsque l'onduleur est monté dans celui-ci, ou d'autre composants d'un ensemble destiné à entrainer un véhicule. En particulier, le décrochement 124 forme une face externe du boitier 100, cette face externe étant comprise dans la deuxième partie 120 du boitier 100.

En particulier, le boitier 100 comprend des parois externes 102 définissant des logements recevant les composants. Les bords de ces parois externes 102 définissent notamment une ouverture permettant d'introduire les composants dans les logements. Ces ouvertures peuvent ensuite être fermées par des couvercles 104 venant contre les bords des parois 102. Notamment, les parois externes 102 de la première partie 110 définissent le premier logement recevant les composants de puissance de l'onduleur 200. Un couvercle 104 ferme ensuite ledit premier logement. En particulier, des parois externes 102 s'étendent depuis le décrochement 124 pour définir le deuxième logement 122, ce deuxième logement 122 recevant les composants de filtrage 125 de l'onduleur 100. Un couvercle 124 vient contre les bords de ces parois externes 102 de la deuxième partie 120 pour fermer le logement 122 de la deuxième partie 120.

Les composants de puissance sont logés dans le premier logement de l'onduleur 200. Ces composants de puissance sont configurés pour convertir une énergie électrique continue en une énergie électrique alternative pour alimenter un moteur électrique alimenté par l'onduleur 200. Ces composants de puissance comprennent notamment des composants semi-conducteurs tels que des diodes et/ou des transistors par lesquels passe l'énergie électrique alimentant le moteur électrique. Le premier logement peut comprendre d'autres composants tels qu'une unité de commande destinée à commander les composants électroniques de puissance. Une telle unité de commande est par exemple une carte électronique sur laquelle sont montés des circuits de commande ; ou une capacité de liaison (ou « DC link capacitor » en anglais) qui est connectée à l'entrée des composants de puissance recevant l'énergie électrique continue.

Les composants de filtrage 125 sont configurés pour filtrer une énergie électrique continue fournie aux composants de puissance. Les composants de filtrage 125 comprennent notamment une ou plusieurs barres de connexion électrique 126 destinées à conduire un courant entre une entrée de l'onduleur 200 connectée à une source de courant continue et une entrée des composants de puissance. La barre de connexion électrique 126 comprend par exemple une barre conductrice électrique munie d'un revêtement isolant électrique, sauf au niveau des bornes électriques de la barre de connexion électrique 126. Les composants de filtrage 125 peuvent en outre comprendre des tores 127 et des capacités 128.

Le décrochement 124 comprend un premier connecteur 123 pour connecter l'onduleur 200 à une source d'énergie électrique continue, notamment à une batterie du véhicule. Ce connecteur 123 pourrait être sur une autre face externe de la deuxième partie 120, par exemple sur la paroi externe 102 ou sur le couvercle 104 de la deuxième partie 120. Le premier connecteur 123 est en particulier à une position distale depuis la première partie 110 de boitier. Les composants de filtrage 125 s'étendent entre cette position distale et le point de décrochement entre la première partie 110 et la deuxième partie 120 de boitier. Le premier connecteur 123 est donc éloigné de la première partie 110 de boitier. Ainsi, la connexion avec une batterie est peu impactée par l'encombrement de la première partie 110 de boitier.

La deuxième portion 120 de boitier peut comprendre en outre un deuxième connecteur externe 129 configuré pour connecter l'onduleur 200 avec un chargeur électrique. Un tel chargeur électrique est notamment embarqué dans le véhicule et configuré pour charger une batterie du véhicule à partir d'un réseau électrique extérieur au véhicule. La batterie électrique est par ailleurs destinée à alimenter l'onduleur 200 par l'intermédiaire du premier connecteur 123 et des composants de filtrage 125. Le deuxième connecteur 129 fait la liaison électrique entre les barres de connexion électrique 126 des composants de filtrage 125 et le chargeur. Grâce au deuxième connecteur 129, le chargeur est connecté à la batterie par l'intermédiaire du deuxième connecteur 129, des barres de connexion électrique 126 et du premier connecteur 123.

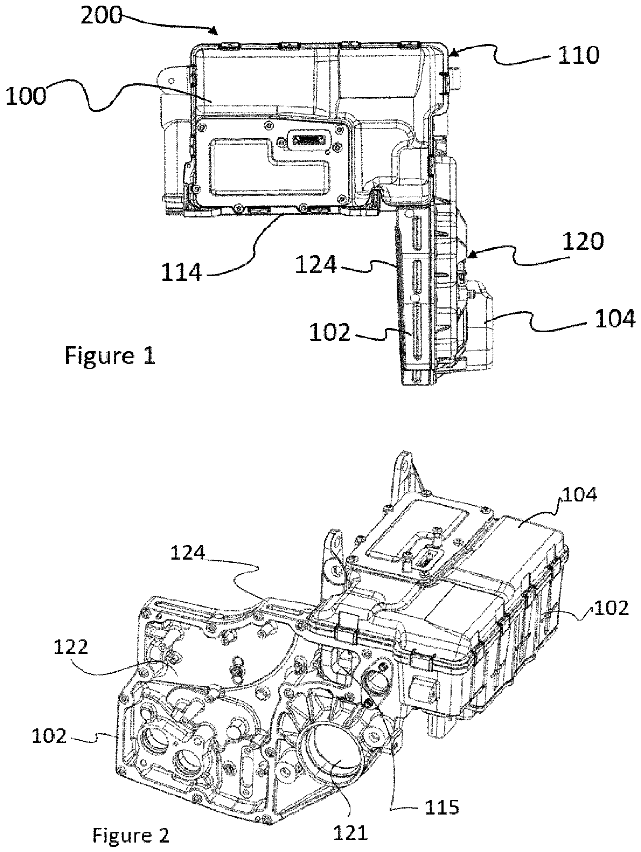

Un passage 115 visible en figure 2 est ménagé à l'intérieur du boitier 100 pour réaliser une voie de passage entre le premier logement et le deuxième logement 122. Ainsi, la connexion entre les composants de filtrage 125 et les composants de puissance est réalisée à l'intérieur du boitier 100. Notamment, ce passage 115 est ménagé dans une paroi interne du boitier 100 qui est commune au premier logement et au deuxième logement 122.

Le décrochement 124 comprend notamment une ouverture 121 destinée à recevoir un arbre d'entrainement d'un véhicule lorsque l'onduleur 200 est monté dans le véhicule. Par exemple, l'ouverture 121 reçoit un arbre d'entrainement issu d'une boite de vitesse. Ainsi, l'onduleur 200 peut être intégré dans le système d'entrainement du véhicule, ce qui améliore la compacité dans le véhicule. En outre, le boitier 100 de l'onduleur 200 contribue au support de l'arbre d'entrainement. L'ouverture 121 pourrait être ailleurs dans la deuxième partie 120, par exemple dans une excroissance du couvercle 104 de la deuxième partie 120 ou dans une excroissance s'étendant depuis le décrochement 124. En particulier, l'ouverture 121 est extérieur au deuxième logement 122. L'ouverture 121 ne débouche pas dans le deuxième logement 122, ce qui évite des problèmes d'étanchéité du deuxième logement 122.

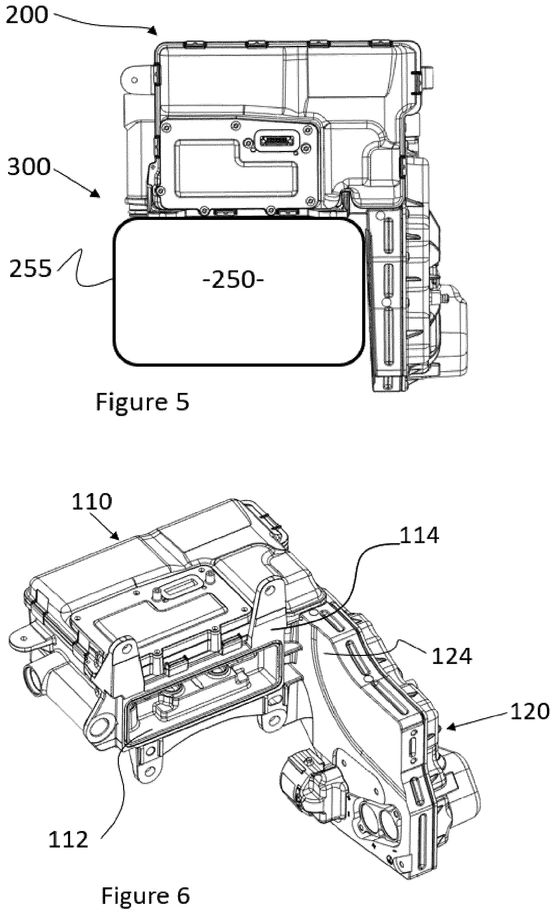

L'onduleur 200 peut être associé à un moteur électrique 250 pour former un ensemble 300 illustré schématiquement en figure 5. Le moteur électrique 250 est logé dans l'espace formé entre la première partie 110 et la deuxième partie 120 du boitier 100 de l'onduleur 200.

Notamment, comme illustré en figure 6, dans l'espace formé entre la première partie 110 et la deuxième partie 120 de boitier, l'onduleur 200 comprend une ouverture 112 qui vient contre une ouverture correspondante du moteur électrique 250, formant ainsi un passage pour une connexion électrique entre l'onduleur 200 et le moteur électrique 250. L'ouverture 112 de l'onduleur 200 est en particulier comprise dans la première partie 110 de boitier, plus particulièrement dans la face externe 114 de la première partie 110 de boitier à partir de laquelle s'étend le décrochement 124. Ainsi, l"intégration de l'onduleur 200 et du moteur électrique 250 dans l'ensemble 300 est amélioré. En particulier, l'ouverture correspondante du moteur électrique 250 est comprise dans une paroi externe du boitier 255 du moteur électrique 250. Un tel boitier 255 comprend un stator et un rotor du moteur électrique 250.

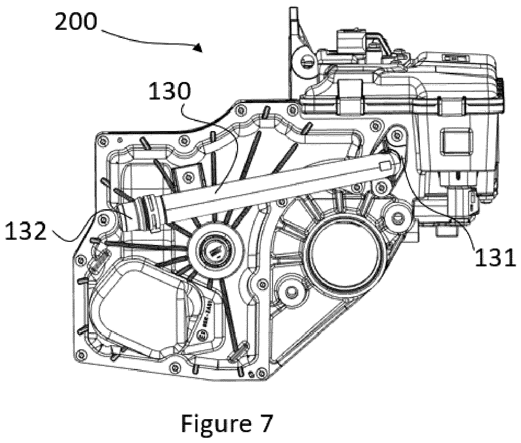

Dans une variante, l'onduleur 200 comprend un circuit de refroidissement des composants de puissance. A cet effet, le circuit de refroidissement est notamment compris dans la première partie 110 de boitier. Par exemple, comme illustré en figure 7, un tube 130 peut alors s'étendre en vis-à-vis de la deuxième partie 120 de boitier pour échanger un liquide de refroidissement avec un canal du circuit de refroidissement. En particulier, le tube 130 s'étend en vis-à-vis d'une face externe de la deuxième partie 120 de boitier qui est opposée au décrochement 124. Notamment, le tube 130 comprend une première extrémité 131 connectée au circuit de refroidissement, et une deuxième extrémité 132 située en vis-à-vis d'un bord de la deuxième partie 120 de boitier. Notamment, la deuxième extrémité 132 du tube 130, le premier connecteur 123 et le deuxième connecteur 129 sont situés sur ou en vis-à-vis de la périphérie de la deuxième partie 120 de boitier pour faciliter leurs connexions avec des connexions de l'onduleur 200 avec d'autres éléments.

L'ensemble 300 est notamment embarqué dans un véhicule afin d'entrainer le véhicule, en particulier depuis une batterie du véhicule connectée au premier connecteur 123 de l'onduleur 200. Notamment, l'ensemble 300 peut être monté avec une boite de vitesse du véhicule, un arbre d'entrainement de la boite de vitesse venant dans l'ouverture 121 de la deuxième partie 120 du boitier 100 de l'onduleur 200.

## Revendications

1. Onduleur (200), notamment configuré pour être embarqué dans un véhicule automobile, comprenant :
- des composants de puissance configurés pour convertir une énergie électrique continue en une énergie électrique alternative de façon à alimenter un moteur électrique (250), notamment destiné à entrainer le véhicule,
- un boitier (100) logeant les composants de l'onduleur (200) et comprenant :
• une première partie (110) formant un premier logement logeant lesdits composants de puissance et
• une deuxième partie (120) formant un deuxième logement (122) logeant des composants de filtrage (125) configurés pour filtrer une énergie électrique continue fournie aux composants de puissance, notamment depuis une batterie du véhicule,
ladite deuxième partie (120) de boitier étant formée au moins en partie par un décrochement (124) par rapport à ladite première partie (110) depuis une face externe (114) du boitier comprise dans la première partie (110).

2. Onduleur (200) selon la revendication 1, dans lequel le décrochement (124) forme une face externe du boitier (100) comprise dans la deuxième partie (120) et s'étend suivant une direction transversale, en particulier perpendiculaire, par rapport à la face externe (114) du boitier comprise dans la première partie (110).

3. Onduleur (200) selon la revendication 1 ou 2, dans lequel une face externe (124) de la deuxième partie (120) de boitier comprend un premier connecteur externe (123) de l'onduleur (200) configuré pour connecter l'onduleur (200) à une source d'énergie électrique continue, notamment une batterie du véhicule.

4. Onduleur (200) selon la revendication 3, dans lequel ledit premier connecteur (123) est à une position distale depuis la première partie (110) de boitier, lesdits composants de filtrage (125) étant positionnés entre cette position distale et le point de décrochement (124) entre la première partie (110) et la deuxième partie (120)

5. Onduleur (200) selon l'une des revendications précédentes, dans lequel la deuxième partie (120) de boitier comprend en outre un deuxième connecteur externe (129) configuré pour connecter l'onduleur (200) avec un chargeur électrique.

6. Onduleur (200) selon l'une des revendications précédentes, dans lequel un passage (115) à l'intérieur du boitier (100) permet une communication entre le premier et le deuxième logement (122)

7. Onduleur (200) selon l'une des revendications précédentes, dans lequel la deuxième partie (120) comprend une ouverture (121) destinée à recevoir un arbre de d'entrainement d'un véhicule lorsque l'onduleur (200) est monté dans un véhicule, en particulier un axe d'entrainement des roues du véhicule.

8. Onduleur (200) selon la revendication précédente, dans lequel ladite ouverture (121) est formée dans ledit décrochement (124).

9. Onduleur (200) selon la revendication 7 ou 8, dans lequel ladite ouverture (121) est formée dans une portion de la deuxième partie (120) de boitier qui est extérieure au deuxième logement (122) logeant les composants de filtrage (125).

10. Ensemble (300) comprenant un onduleur (200) selon l'une des revendications précédentes et un moteur électrique (250) configuré pour être entrainé par ledit onduleur (200).

11. Ensemble (300) selon la revendication 10, dans lequel ledit moteur électrique (250) est logé au moins en partie dans l'espace formé entre la première partie (110) et la deuxième partie (120) de boitier, en particulier dans l'espace formée entre la face externe (114) de la première partie (110) et le décrochement (124).

12. Ensemble (300) selon la revendication 11, dans lequel une ouverture du moteur électrique (250) et une ouverture (112) de l'onduleur (200) viennent l'une contre l'autre dans l'espace formé entre la première partie (110) et la deuxième partie (120) de boitier de façon à permettre un passage étanche pour une connexion électrique entre l'onduleur (200) et le moteur électrique (250).
